# EUROPEAN PATENT APPLICATION

(11) **EP 0 959 390 A1**
(43) Date of publication of application: **24.11.1999**
(21) Application number: 98830305.3
(22) Date of filing: 20.05.1998
(51) Int. Cl.: G03F 7/42, H01L 21/311

(54) **Photoresist removal process.**

(71) Applicant: STMicroelectronics S.r.l., 20041 Agrate Brianza (Milano) (IT)
(72) Inventor: Romanelli, Claudia, 20064 Gorgonzola (MI) (IT)
(74) Representative: Dini, Roberto, Dr. Ing.

(57) **Abstract**

A photoresist removal process from a semiconductor material surface, which provides the use of a removal solution comprising a decomposition agent dissolved in a carrier phase, where said decomposition agent exploits its action directly on the semiconductor material surface.

According to the present invention said photoresist removal process is a spray process, where said removing solution is sprayed on the semiconductor material surface within a closed system at room temperature.

## Description

The present invention concerns a photoresist removal process from a semiconductor material surface, which provides the use of a removal solution comprising a decomposition agent dissolved in a carrier phase, said decomposition agent exploiting its action directly on the semiconductor material surface.

In the field of electronic technologies and manufacture of electronic circuits lithographic processes are universally used, which include masking procedures for the silicon wafers using photoresist, i.e. a radiation sensitive compound. Radiations cause photoresist structure to change. Its solubility with respect to a developing solution is substantially modified . Said developing solution is used to selectively remove the areas exposed to radiations (or not exposed in the instance of a negative photoresist).

A procedure applied for photoresist removal is the so-called 'stripping' or via wet etching peeling process. When applying this process, the photoresist is detached from the silicon wafer and subsequently decomposed in products that will be removed from the process chamber.

A well known procedure uses a solution called SPM solution (Sulphuric Peroxide Mixture), containing sulphuric acid and hydrogen peroxide H₂0₂. Sulphuric acid acts as a chemical etchant agent, whereas peroxide acts as a decomposing agent. SPM solution is produced in a tank, whose contents is then sprayed inside the process chamber. SPM solution will then be recycled into the tank. Photoresist is lifted off from the wafer through the action of the sulphuric acid and carried along with the SPM solution recycled into the tank, where peroxide exploits its action by oxidizing and decomposing it to water and gas.

A similar process requires to add peroxide spikes in the tank to replace the peroxide that is reduced to water and oxygen during oxidation reaction. Said procedure is carried out at high temperature for an increased reactivity rate of the solution, in order to reduce process time.

However, adding spikes of peroxide is not enough to remove the main drawback from said process. Both peroxide reduction and photoresist oxidation in fact produce water, thus reducing the SPM solution and limiting its efficiency.

A photoresist removal process using a liquid phase is also known. An ozone based solution is applied to obtain photoresist removal by decomposing the photoresist directly on the wafer surface. According to this process the wafer has to be fully dipped in the liquid phase contained in a vessel within an open hood. Since temperature is low, ozone solubility in the carrier liquid, e.g. water, is enhanced.

However, said process is not very efficient for photoresist removal if it is not a so-called 'ashed' photoresist, that is photoresist preliminarly burnt through a bombing with ozone ions. Said photoresist burning is carried out, for instance, when the wafer has undergone ionic implantation phases, through which the high energy of incident ions causes structural changes to the photoresist, making it more resistant to etchant agents.

It is the object of the present invention to solve the above drawbacks and provide a photoresist removal process, which is improved with respect to the solutions already known.

In such a frame, it is the main object of the present invention to provide a photoresist removal process that allows a chemical etching process to the photoresist on the silicon wafer not influenced by the decomposition products of the photoresist.

A further object of the present invention is to provide a photoresist removal process, which is suitable to remove both ashed type photoresist and non- ashed photoresist.

A further object of the present invention is to provide a photoresist removal process to be efficiently used at process temperatures approaching room temperature.

A further object of the present invention is to provide a photoresist removal process, which is less harmful for its chemical discharge.

A further object of the present invention is to provide photoresist removal process, which is cost-effective and allows processing of a large number of wafers using small quantities of chemical agents

To reach this purpose it is the object of the present invention to provide a photoresist removal process incorporating the features of the annexed claims.

Further purposes, features and advantages of the present invention will become apparent from the following detailed description and annexed drawings, which are supplied by way of a non limiting example, wherein:

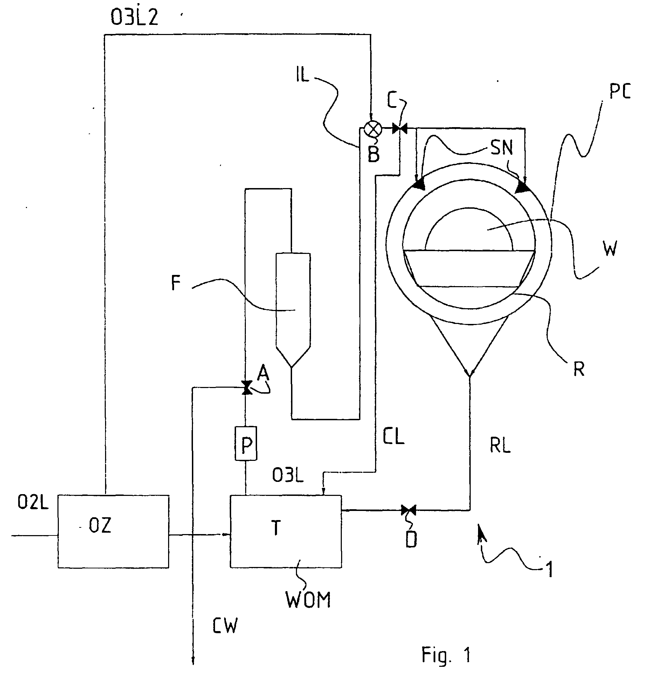

- Fig. 1 shows a general block schematics of the photoresist removal process according to the present invention.

The annexed Figure 1 shows schematically the photoresist removal process according to the present invention.

In this figure a spray processing system 1 is represented, which comprises a process chamber PC containing a rotor R, which rotates at variable speed rates ranging from 45 to 1100 revolutions per minute, where silicon wafers W covered with the photoresist to be removed are located as a whole. Specifically, wafers are used whereon photoresist type HPR504 had been deposited, pre-treated through a 130°C thermal step, with thickness of about 12000 Å. A stabilization step through UV radiation may also be provided. The spray processing system 1 shown in Fig. 1 is based on a Semitool Spray Acid Tools spray processing system. The process chamber PC is equipped with spray nozzles SN, representing the outlets of an inlet line IL through which the contents of a tank T is introduced into the process chamber PC through a filter F. A pump P is located upstream the filter F and an outlet valve A allows discharge of the contents of the inlet line IL in a chemical discharge line CW.

Moreover, the tank T is connected with a recycling line RL from the process chamber PC, which can be activated by a proper recycle valve D. An ozone line O3L is also entering the tank T from an ozonizer OZ. The ozonizer OZ is connected with an oxygen line O2L and will also let ozone directly in the inlet line IL through a further ozone line O3L2 and inlet valve B. Finally, a recycle valve C is provided, which connects the inlet line IL with a recycle line CL. Said recycle line CL leads to the tank T.

The ozonizer OZ produces ozone O₃ from oxygen O₂ from the oxygen line O2L, and feeds it to the tank T through the ozone line IO3. A water-ozone mixture WOM is available in the tank T, where water acts as a carrier phase. The tank T is controlled thermostatically at 20°C. Ozone concentration at the ozonizer outlet OZ contains 12% molecular oxygen.

The spray processing system 1 is kept pressurized during operation, or photoresist removal process, i.e. it is a closed system. Specifically, the tank T, inlet line IL, process chamber PC and recycle line RL are pressurized.

Process operation is as follows:
- the water-ozone mixture WOM is transferred through the inlet line IL to the process chamber PC, where it is sprayed through spraying nozzles SN on wafers W rotated as a whole by the rotor R;
- ozone develops a simultaneous chemical and solubilization action on the photoresist;
- reaction products, i.e. water and gas, are recycled to the tank T through the recycle line RL and eventually removed through the outlet line CW.

Thus, photoresist removal is performed through a vertical chemical etching mechanism with solubilization on wafers W. The higher the ozone contents in the water-ozone mixture WOM, the faster the reaction rate on the wafers surface W.

The ozonizer OZ lets ozone both in the tank T and inlet line IL, to make sure that the water-ozone mixture WOM always has a high contents of ozone to remove any photoresist remains. A further ozone injection from the ozonizer OZ is performed on the inlet line IL near the process chamber PC to enrich the water-ozone mixture OZ with ozone.

The filter F is used to ensure removal of all photoresist remains from the water-ozone mixture WOM. In particular, the filter F represented in Fig. 1 is a 0.2 µm filter, which is also used for a recycling step of the water-ozone solution WOM at regular time intervals, when the removal process is not operating. In this instance both the recycle valve C and recycle line CL are used.

The spray processing system 1 implementing the photoresist removal process according to the present invention, inclusive of the above parameters, can reach an 'etch rate' or removal rate of 225 Å per minute and operate on a number of wafers W as a whole up to 25 silicon wafers at a time.

According to the above description the features of the present invention are clear and also its advantages will become obvious.

The photoresist removal process according to the present invention will advantageously allow execution of a chemical etching process to the photoresist on the silicon wafer not influenced by the products of the photoresist decomposition process diluting the removing solution, since the chemical etching and solubilization are performed directly on the wafer surface.

Moreover, the photoresist removal process according to the present invention is suitable to remove both the ashed photoresist and non ashed photoresist, since ozone is a highly oxidizing agent, whose concentration in the water-ozone mixture can be varied as desired.

Additionally, the photoresist removal process according to the present invention can be advantageously used at room temperature. Since said systems, in fact, are kept closed, it is possible to reach a high ozone concentration in water in spite of a relatively high temperature.

A further advantage is that the photoresist removal process is less harmful for the chemical outlet line as it does not contain any acid agents, such as sulphuric acid.

Finally, the photoresist removal process is particularly cost-effective, since it simply requires to add an oxygen line and an ozonizer to a conventional spray system for handling a large number of wafers with small quantities of chemical agents.

It is obvious that many changes are possible for the man skilled in the art to the photoresist removal process described by way of example, without departing from the novelty spirit of the innovative solution, and it is also clear that in practical actuation of the present invention the components may often differ in form and size from the ones described and be replaced with technical equivalent elements.

A possible embodiment may provide initially an acid pH in the starting water-ozone solution to help photoresist decomposition in the tank and increase the etch rate.

The filter can be alternatively positioned in the recycle line.

## Claims

1. A photoresist removal process from a semiconductor material surface, which provides the use of a removal solution comprising a decomposition agent dissolved in a carrier phase, said decomposition agent exploiting its action directly on the semiconductor material surface, characterized in that said photoresist removal process is a spraying process, which is provided to spray said removing solution (WOM) on the semiconductor material surface (W) within a closed system.

2. A photoresist removal process from a semiconductor material surface according to claim 1, characterized in that said decomposition agent comprises ozone.

3. A photoresist removal process from a semiconductor material surface according to claim 2, characterized in that said carrier phase is water.

4. A photoresist removal process from a semiconductor material surface according to claim 1, characterized in that it is provided to maintain the carrier phase in a tank connected with a process chamber through a transfer line (IL) and inject the decomposition agent in said transfer line (IL).

5. A photoresist removal process from a semiconductor material surface according to claim 4, characterized in that said decomposition agent is injected into a plurality of points on said transfer line (IL).

6. A photoresist removal process from a semiconductor material surface according to claim 5, characterized in that it is provided to recover the carrier phase through a recycle line (RL), comprising a filter (F).

7. A photoresist removal process from a semiconductor material surface according to claim 5, characterized in that an acid is added to the carrier phase.

8. A photoresist removal process from a semiconductor material surface according to claim 6, characterized in that it comprises a recycle step of the removing solution (WOM) at regular time intervals while the process chamber (PC) is empty.

9. A spray processing system for semiconductor material surfaces comprising a tank, a process chamber and nozzles to spray the tank contents in the process chamber, characterized in that it also comprises an ozonizer device (OZ) connected at least with the tank (T).

10. A spray processing system for semiconductor material surfaces according to claim 9, characterized in that the ozonizer device (OZ) is connected on one or more points with a transfer line (IL) from the tank (T) to the process chamber (PC).

11. Semiconductor material processed according to the process and/or system as claimed in the previous claims.
